## Europäisches Patentamt
## European Patent Office
## Office européen des brevets

(19)

(11) Numéro de publication: **0 015 202**
**B1**

(12)

# FASCICULE DE BREVET EUROPEEN

(45) Date de publication du fascicule du brevet:
06.04.83

(51) Int. Cl.³: **B 29 D 11/00**, B 29 C 1/00

(21) Numéro de dépôt: **80400224.4**

(22) Date de dépôt: **18.02.80**

(54) **Joint annulaire propre au moulage de lentilles ophtalmiques ou optiques en matière organique, et procédé de mise en oeuvre d'un tel joint.**

(30) Priorité: **23.02.79 FR 7904717**

(43) Date de publication de la demande:
**03.09.80 Bulletin 80/18**

(45) Mention de la délivrance du brevet:
**06.04.83 Bulletin 83/14**

(84) Etats contractants désignés:
**DE GB IT**

(56) Documents cités:
**US-A-3 136 000**
**US-A-3 881 683**

(73) Titulaire: **ESSILOR INTERNATIONAL Cie Générale d'Optique, 1 Rue Thomas Edison Echat 902, F-94028 Creteil Cedex (FR)**

(72) Inventeur: **Blandin, Denis, 11 Allée des Alpes, F-94350 Villiers-sur-Marne (FR)**

(74) Mandataire: **CABINET BONNET-THIRION, 95 Boulevard Beaumarchais, F-75003 Paris (FR)**

ACTORUM AG

Joint annulaire propre au moulage de lentilles ophtalmiques ou optiques en matière organique, et procédé de mise en œuvre d'un tel joint

La présente invention concerne d'une manière générale le moulage de lentilles ophtalmiques ou optiques en matière organique.

Ainsi qu'on le sait, un tel moulage se pratique usuellement entre deux coquilles de moulage maintenues à distance l'une de l'autre par un joint annulaire formant entretoise et assurant l'étanchéité de la cavité de moulage ainsi définie entre ces coquilles de moulage.

En pratique, pour le maintien de celles-ci au contact du joint annulaire qui les sépare, il est couramment mis en œuvre à ce jour une pince élastique portant conjointement sur l'une et l'autre de ces coquilles de moulage, de part et d'autre dudit joint annulaire, voir US-A-3 881 683.

Ainsi qu'on le sait également, les matières organiques les plus communément mises en œuvre pour le moulage de lentilles ophtalmiques ou optiques nécessitent pour leur prise, qui correspond à une polymérisation, un échauffement, et, au cours de cette prise, il se produit un retrait non négligeable de la matière.

Il va de soi que les coquilles de moulage doivent être en mesure de suivre un tel retrait.

Dans un premier temps, les coquilles de moulage suivent d'elles-mêmes, en raison de leur élasticité propre, ce retrait, sous la sollicitation conjointe de la matière moulée et de la pince élastique.

Mais, le joint interposé entre les coquilles de moulage s'opposant à tout mouvement relatif de celles-ci de nature à leur permettre de suivre un retrait plus accentué de la matière, il faut, dans un deuxième temps, retirer ce joint, et lui substituer un produit pâteux propre à assurer la poursuite à l'abri de l'air de la polymérisation en cours.

Ainsi, avec un tel processus, il faut d'une part mettre en œuvre, initialement, non seulement un joint annulaire, mais encore une pince élastique, et d'autre part, retirer, ultérieurement, ce joint, aussi bien d'ailleurs que la pince.

Un tel processus s'en trouve compliqué, et donc coûteux; en outre, il implique un fractionnement en deux phases du traitement thermique nécessaire à la polymérisation recherchée, à savoir une phase de prépolymérisation, à température modérée, avec joint et pince, puis, après retrait de ceux-ci, une phase de polymérisation définitive, à température plus poussée, et il en résulte inévitablement des malfaçons pour certaines lentilles ainsi obtenues, conduisant au rejet de celles-ci.

Il a cependant été proposé, dans le brevet des Etats-Unis d'Amérique no 3 555 610, la mise en œuvre d'un joint annulaire de nature à permettre une simplification de ce processus et évitant tout fractionnement du traitement thermique.

En effet, ce joint présente, à sa périphérie interne, une arête annulaire, qui est formée à l'extrémité d'une collerette annulaire élastiquement déformable axialement, et par laquelle il est apte à coopérer en étanchéité avec l'une des coquilles de moulage.

De la capacité de déformation axiale élastique que présente la collerette annulaire ainsi mise en œuvre dans un tel joint, il résulte qu'il est possible, d'une part, de rapprocher l'une de l'autre les coquilles de moulage après mise en place de la matière à mouler, et de créer ainsi entre ces coquilles de moulage, lorsqu'on les relâche, et que la collerette annulaire du joint qui les sépare tend à revenir à sa configuration initiale, un effet de ventouse suffisant pour assurer en toute sécurité un maintien convenable de chacune de ces coquilles de moulage au contact du joint, sans qu'il soit nécessaire de mettre en œuvre à cet effet une quelconque pince élastique, et, d'autre part, de laisser en place le joint jusqu'au stade ultime de polymérisation de la matière moulée, l'élasticité de la collerette annulaire que présente ce joint permettant à celui-ci de s'accommoder du mouvement relatif nécessaire aux coquilles de moulage pour suivre complètement le retrait de cette matière au cours de sa polymérisation.

Mais, dans le brevet des Etats-Unis d'Amérique en question, la collerette annulaire proposée ne s'étend en pratique qu'axialement, cette collerette ne faisant saillie que sur la face transversale correspondante du joint.

Il en résulte que sa capacité de déformation élastique est essentiellement due aux possibilités d'écrasement qu'elle offre.

De telles possibilités d'écrasement sont en réalité mal contrôlées, et, comme précédemment, il en résulte des déboires de fabrication.

En outre, dans le brevet des Etats-Unis d'Amérique mentionné ci-dessus, aucune disposition particulière n'est proposée pour contrôler le mouvement de rapprochement exercé entre les coquilles de moulage lors de leur mise en place.

Il peut en résulter, d'une fabrication à une autre, des différences d'épaisseur notables entre les lentilles obtenues.

Si de telles différences d'épaisseur ne constituent pas un inconvénient majeur pour les lentilles de correction semi-finies, celles-ci subissant ultérieurement un traitement d'usinage de nature à leur conférer leur configuration définitive, il n'en est pas de même pour les lentilles de correction finies, aussi bien que pour les lentilles afocales, et plus précisément pour les lentilles solaires, aucun traitement d'usinage n'étant en principe appliqué à celles-ci après moulage.

La présente invention a d'une manière générale pour objet de pallier ces inconvénients.

De manière plus précise, elle a tout d'abord pour objet un joint annulaire propre au moulage de lentilles ophtalmiques ou optiques en matière organique, du genre comportant, axialement à distance l'une de l'autre, à sa périphérie interne, deux arêtes annulaires par lesquelles il est apte à coopérer en étanchéité avec deux coquilles de moulage, l'une au moins desdites arêtes annulaires étant formée à l'extrémité d'une collerette annulaire élastiquement déformable issue dudit joint, et caractérisé en ce que ladite collerette annulaire s'étend globalement en biais vis-à-vis de l'axe du joint, cette collerette faisant saillie non seulement sur la face transversale correspondante du joint, mais encore sur la face périphérique interne de celui-ci et présentant, en section axiale, un profil triangulaire d'angle au sommet aigu en sorte que ladite collerette est apte à travailler en flexion.

Ainsi, il n'est pas nécessaire que le joint présente par lui-même une relative souplesse.

Au contraire, il peut avantageusement être en matériau relativement dur, ce qui évite d'avoir à le rigidifier, sans pour autant en craindre des déformations intempestives lors du processus de moulage auquel il participe.

La présente invention a encore pour objet un procédé de mise en œuvre de nature à permettre de tirer le meilleur parti de cet avantage de travail à la flexion du joint.

Ce procédé de mise en œuvre est du genre suivant lequel, une dose convenable de matière organique à mouler ayant été mise en place entre deux coquilles de moulage séparées l'une de l'autre par le joint annulaire, soit après mise en place d'une seule des coquilles de moulage, soit après mise en place de l'une et de l'autre de celles-ci, on exerce axialement une pression sur l'une desdites coquilles de moulage tout en contrebutant l'autre et est caractérisé en ce que, pour développer ladite pression, on met en œuvre un doigt mobile dont on contrôle la course.

Grâce à un tel procédé, une grande constance d'épaisseur peut être observée, avec une bonne reproductivité, dans les lentilles ophtalmiques ou optiques obtenues.

Les caractéristiques et avantages de l'invention ressortiront d'ailleurs de la description qui va suivre, à titre d'exemple, en référence aux dessins schématiques annexés sur lesquels:

la fig. 1 est une vue en élévation-coupe d'un joint annulaire suivant l'invention;

les figs. 2A, 2B, 2C, 2D, 2E et 2F sont des vues en coupe axiale illustrant diverses phases successives du procédé de mise en œuvre de ce joint annulaire;

la fig. 3 est une vue en coupe axiale analogue à celles des figs. 2, après retrait du joint annulaire suivant l'invention;

les figs. 4 à 6 sont des vues en coupe axiale reprenant pour partie la fig. 1 et se rapportant chacune respectivement à une variante de réalisation du joint annulaire suivant l'invention.

Dans la forme de réalisation illustrée par ces figures, le joint annulaire 10 suivant l'invention fait corps avec une jupe périphérique 11 qui, au moins en apparence, est globalement cylindrique, mais qui, en réalité, pour des raisons de fabrication par moulage est globalement conique ou biconique, et il forme globalement un cordon annulaire en saillie sur la face interne de cette jupe, dans la partie médiane de celle-ci.

La jupe périphérique 11 s'étend donc dans ce cas axialement de part et d'autre du joint annulaire 10, c'est-à-dire aussi bien vers le haut, en 12A, que vers le bas, en 12B.

Dans l'exemple de réalisation représenté, et pour des raisons qui apparaîtront ultérieurement, les parties supérieure 12A, inférieure 12B de la jupe 11 comportent, de place en place, des échancrures 14.

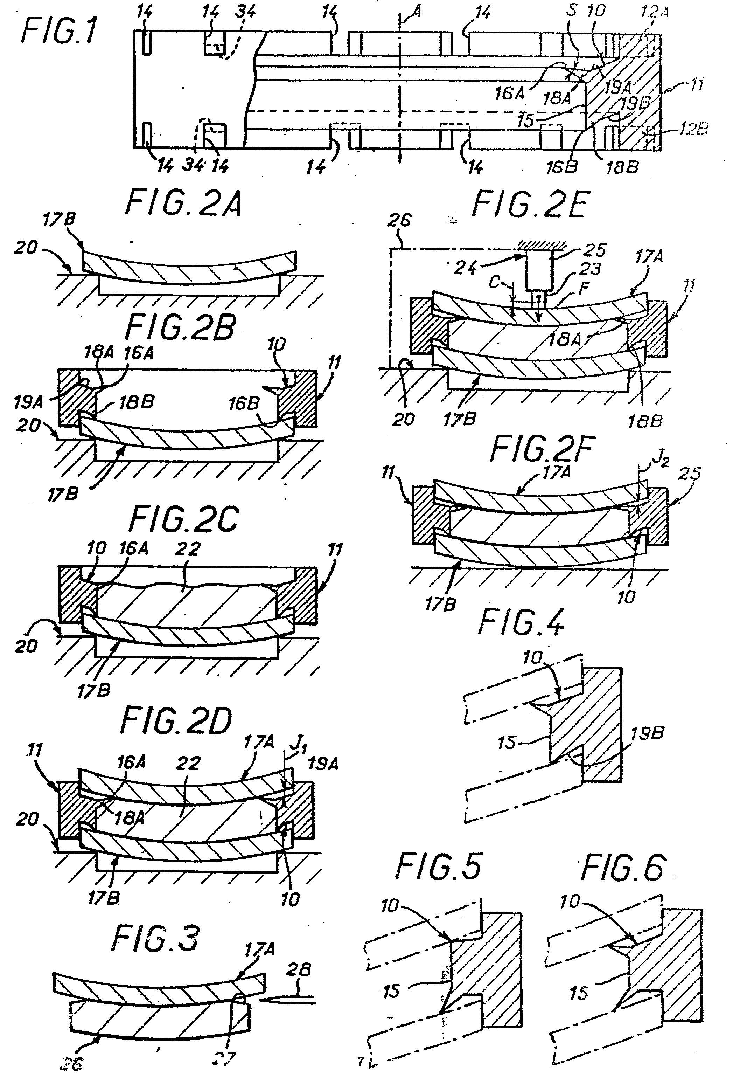

Dans l'exemple de réalisation représenté, le joint annulaire 10 s'étend globalement obliquement vis-à-vis de son axe A, qui forme également l'axe de la jupe périphérique 11, tel que schématisé en traits interrompus à la fig. 1, en se rapprochant de cet axe en direction du bas; il forme donc globalement un angle obtus avec la partie supérieure 12A de la jupe 11, et un angle aigu avec la partie inférieure 12B de celle-ci.

A se périphérie interne, qui est globalement définie par une surface cylindrique conique, ou cylindrique et conique 15, le joint annulaire 10 comporte, axialement à distance l'une de l'autre, deux arêtes annulaires 16A, 16B, par lesquelles, ainsi qu'il apparaîtra ci-après, il est apte à coopérer en étanchéité avec deux coquilles de moulage 17A, 17B.

Suivant l'invention, l'une au moins de ces arêtes annulaires 16A, 16B, et il s'agit de l'arête 16A dans les formes de réalisation représentées sur les figs. 1 à 4, est formée à l'extrémité d'une collerette élastiquement déformable 18A, qui est issue du joint annulaire 10, en étant venue d'un seul tenant par moulage de celui-ci, et qui s'étend globalement en biais vis-à-vis de l'axe A de ce joint, cette collerette annulaire 18a faisant saillie non seulement sur la face transversale oblique 19A correspondante dudit joint, mais encore sur la face périphérique interne 15 de celui-ci.

En section axiale, la collerette annulaire 18A a un profil triangulaire d'angle au sommet S aigu.

Cet angle au sommet S est de préférence inférieur à 40 degrés mais cette valeur ne doit pas être considérée comme limitative de l'invention.

Il suffit en effet, pour la mise en œuvre de l'invention, et ainsi qu'il apparaîtra ci-après, que la collerette annulaire 18A soit en mesure de travailler élastiquement en flexion lorsqu'elle est l'objet d'une sollicitation s'exerçant parallèlement à l'axe A du joint.

Dans la forme de réalisation illustrée par la fig. 1, l'arête 16B est également formée à l'extrémité d'une collerette annulaire élastiquement déformable 18B, mais celle-ci s'étend globalement parallèlement à l'axe A du joint 10, en ne faisant saillie que sur la face transversale correspondante 19B de celui-ci, et non pas sur sa face périphérique interne 15.

La capacité de déformation de cette collerette annulaire 18B ne peut donc s'exercer dans ce cas qu'axialement, et, de ce fait, elle est notablement moindre que celle de la collerette annulaire 18A.

Pour le moulage à l'aide du joint suivant l'invention d'une lentille optique ou ophtalmique en matière organique, on peut, suivant un premier mode de mise en œuvre, procéder de la manière suivante.

Tout d'abord, on place sur une platine d'appui fixe 20 la coquille de moulage 17B, fig. 2A, qui se trouve ainsi contrebutée; il s'agit, en pratique, d'une coquille de moulage à face de moulage concave, réalisée par exemple en verre, et en particulier en verre trempé, et présentant de préférence une épaisseur sensiblement uniforme, ainsi qu'il est usuel dans ce domaine.

Sur cette première coquille de moulage 17B, on place ensuite le joint annulaire 10 suivant l'invention, fig. 2B; la partie inférieure 12B de la jupe 11 dont est solidaire le joint 10 assure avantageusement, de manière connue en soi, un centrage convenable de ce joint 10 vis-à-vis de la coquille de moulage 17B.

Quoi qu'il en soit, le joint annulaire 10 suivant l'invention vient porter par son arête annulaire 16B sur la face de moulage concave de la coquille de moulage 17B.

On place ensuite sur celle-ci, fig. 2C, une dose convenable 22 de matière organique à mouler; il s'agit par exemple du monomère connu sous la désignation commerciale «CR 39», à savoir le polyéthylène glycol di-allyle di-carbonate, additionné d'un catalyseur, par exemple du percarbonate d'isopropyle.

On place ensuite sur le joint annulaire 10, fig. 2D, la coquille de moulage 17A, qui est une coquille de moulage à surface de moulage convexe, et qui présente une constitution analogue à celle de la coquille de moulage 17A.

En variante, suivant un deuxième mode de mise en œuvre, et de manière connue en soi, la dose de matière organique à mouler n'est mise en place qu'après engagement de la coquille de moulage 17A sur le joint annulaire 10, à l'aide par exemple d'une buse d'injection convenablement insérée entre cette coquille de moulage et ce joint (non représenté).

Quoi qu'il en soit, la partie supérieure 12A de la jupe périphérique 11 assure de manière connue un centrage convenable de la coquille de moulage 17A vis-à-vis du joint annulaire 10, et cette coquille de moulage 17a vient porter sur ce joint par l'arête annulaire 16A de celui-ci.

Un jeu J1 subsiste alors axialement entre la coquille de moulage 17A et la face transversale 19A correspondante du joint annulaire 10.

La coquille de moulage 17B étant contrebutée par la platine d'appui 20, sur laquelle elle repose, on exerce alors une pression axiale sur la coquille de moulage 17A, suivant la flèche F de la fig. 2E, de manière à obtenir l'effet de ventouse recherché.

Suivant l'invention, pour développer cette pression axiale, on met en œuvre un doigt mobile 23 dont on contrôle rigoureusement la course C entre sa position initiale, schématisée en traits interrompus à la fig. 2E, pour laquelle il entre en contact avec la coquille de moulage 17A, et sa position finale, par laquelle il définit également la position finale de la coquille de moulage 17A.

De préférence, mais non obligatoirement, il s'agit d'un doigt mobile à force d'appui constante.

Par exemple, il peut très simplement s'agir du piston d'un vérin pneumatique ou hydraulique 24 dont le corps 25 est, tel que schématisé en traits interrompus à la fig. 2E, solidaire d'une potence 26 montée rotative, autour d'un axe vertical, vis-à-vis de la platine d'appui 20.

Quoi qu'il en soit, le déplacement de la coquille de moulage 17A en direction de la coquille de moulage 17B, qui est fixe, a un double effet: d'une part il contraint la matière à mouler en surplus à refluer vers l'extérieur, et ce reflux se trouve facilité par les échancrures 14 des parties supérieure 12A et inférieure 12B de la jupe périphérique 11; d'autre part, il provoque une déformation élastique de la collerette annulaire 18A, par flexion, et, dans une moindre mesure, de la collerette annulaire 18B, par écrasement.

C'est de cette déformation élastique que résulte l'effet de ventouse recherché: en effet, lorsque la coquille de moulage 17A est relâchée, fig. 2F, les collerettes annulaires 18A, 18B ont tendance à reprendre élastiquement leur configuration initiale; du fait du mouvement rétrograde qui en résulte pour la coquille de moulage 17A, il se développe, dans la cavité de moulage confinée par celle-ci conjointement avec le joint annulaire 10 et la coquille de moulage 17A, une dépression caractéristique d'un tel effet de ventouse, et suffisante pour assurer un maintien convenable des coquilles de moulage 17A, 17B contre le joint annulaire 10.

Aucune pince n'est donc nécessaire pour un tel maintien, et l'ensemble 25 constitué par les coquilles de moulage 17A, 17B, le joint annulaire 10 et la matière moulée confinée par ces pièces, est placé, sans autre, dans une étuve d'air ou à eau, où un traitement thermique, propre à la polymérisation de cette matière moulée, lui est appliqué sans discontinuité.

En pratique, la pression axiale appliquée initialement à la coquille de moulage 17B est conduite de manière à ce que, après relâchement de celle-ci, il subsiste, entre cette coquille de moulage 17A et la paroi transversale 19A correspondante du joint 10, un jeu axial J2 suffisant pour permettre à la coquille de moulage 17A de suivre le retrait de la matière moulée sans venir en appui contre la face transversale 19A du joint annulaire 10.

Après polymérisation de la matière moulée, le joint annulaire 10 est retiré. En général, on retire ensuite la coquille de moulage 17B, la lentille 26 obtenue adhérant usuellement plus fortement à la coquille de moulage 17A, tel qu'illustré par la fig. 3; toutefois, dans le cas où la coquille de moulage 17B, qui est celle à surface de moulage concave, constitue une coquille de moulage «chère», on retire d'abord de préférence la coquille de moulage 17A, le dégagement de celle-ci libérant les contraintes de l'ensemble dues au retrait de la matière moulée lors de sa polymérisation, ce qui permet d'éviter un endommagement éventuel de la coquille de moulage 17B.

Quoi qu'il en soit, en raison de la collerette annulaire 18A suivant l'invention, la lentille 26 obtenue présente au voisinage de la coquille de moulage 17A, un décrochement 27 permettant l'insertion entre elle et la coquille de moulage 17A d'un quelconque outil 28, une spatule par exemple, propre à en faciliter la séparation vis-à-vis de cette coquille de moulage 17A.

Dans la variante de réalisation illustrée par la fig. 4, l'arête annulaire 16B du joint 10 est directement définie par celui-ci, sans individualisation d'une quelconque collerette, cette arête 16B résultant directement de l'intersection d'une part de la face périphérique interne 15 du joint annulaire 10 et d'autre part de la face transversale 19B correspondante de celui-ci.

Dans la variante de réalisation illustrée par la fig. 5, une disposition inverse de celle de la fig. 4 est adoptée: c'est l'arête 16B qui est formée en bout d'une collerette annulaire élastiquement déformable s'étendant en biais vis-à-vis de l'axe de l'ensemble, l'arête 16A étant directement définie par le joint 10, sans individualisation d'une quelconque collerette.

Suivant une autre variante, fig. 6, les arêtes 16A, 16B sont l'une et l'autre formées en bout d'une collerette élastiquement déformable s'étendant en biais vis-à-vis de l'axe de l'ensemble.

Il est par ailleurs à noter que, dans le cas d'une coquille de moulage à surface de moulage sphérique, soit concave, soit convexe, c'est de préférence du côté de cette coquille de moulage à surface de moulage sphérique qu'est adoptée la disposition à collerette suivant l'invention, car les conditions d'étanchéité à respecter sont alors plus favorables pour une telle surface de moulage sphérique.

Par ailleurs, la partie supérieure 12A de la jupe périphérique 11 peut être circulairement continue, ses échancrures 14 étant alors remplacées par des passages à section transversale fermée, tel que schématisé en traits interrompus pour l'une de ces échancrures, en 34, à la fig. 1, et il en est de même pour la partie inférieure 12B de ladite jupe périphérique 11.

En réalité, une telle jupe périphérique 11, qui n'intervient que pour assurer un centrage convenable des coquilles de moulage, n'est pas rigoureusement nécessaire à la mise en œuvre du joint suivant l'invention, et peut donc être éliminée, notamment lorsque d'autres moyens sont par ailleurs mis en œuvre pour assurer un tel centrage.

Quoi qu'il en soit, le joint annulaire suivant l'invention peut être réalisé d'un seul tenant par moulage d'une matière synthétique du type élastomère thermoplastique.

De préférence une telle matière est choisie pour présenter une dureté notable, et par exemple une dureté Shore A de 90 ou voisine de celle-ci, et pour conserver, dans la plage de température du traitement thermique de polymérisation à appliquer, ses propriétés initiales.

## Revendications

1. Joint annulaire (10) propre au moulage de lentilles ophtalmiques en matière organique, du genre comportant, axialement à distance l'une de l'autre, à sa périphérie interne, deux arêtes annulaires (16A, 16B) par lesquelles il est apte à coopérer en étanchéité avec deux coquilles de moulage (17A, 17B), l'une (16A) au moins desdites arêtes annulaires étant formée à l'extrémité d'une collerette annulaire élastiquement déformable (18A) issue dudit joint, caractérisé en ce que ladite collerette annulaire (18A) s'étend globalement en biais vis-à-vis de l'axe du joint, cette collerette (18A) faisant saillie non seulement sur la face transversale correspondante (19A) du joint, mais encore sur la face périphérique interne (15) de celui-ci, et présentant, en section axiale, un profil triangulaire d'angle au sommet aigu, en sorte que ladite collerette (18A) est apte à travailler en flexion.

2. Joint annulaire suivant la revendication 1, caractérisé en ce que l'angle du sommet de la collerette (18A) est de préférence inférieur à 40 degrés.

3. Joint annulaire suivant l'une quelconque des revendications 1, 2, caractérisé en ce que son autre arête annulaire (16B) est également formée à l'extrémité d'une collerette annulaire élastiquement déformable (18B).

4. Procédé pour la mise en œuvre du joint annulaire (10) selon l'une quelconque des revendications 1 à 3, du genre suivant lequel, une dose convenable de matière organique à mouler ayant été mise en place entre deux coquilles de moulage (17A, 17B) séparées l'une de l'autre par le joint annulaire (10), soit après mise en place d'une seule des coquilles de moulage, soit après mise en place de l'une et de l'autre de celles-ci, on exerce axialement une pression sur l'une desdites coquilles de moulage (17A, 17B) tout en contrebutant l'autre, caractérisé en ce que, pour développer ladite pression, on met en œuvre un doigt mobile (23) dont on contrôle la course.

## Claims

1. An annular gasket (10) for the moulding of ophthalmic lenses of organic material, of the kind comprising, axially spaced from each other, at its inner periphery, two annular ridges (16A, 16B) by which it is capable of sealingly cooperating with two mould shells (17A, 17B), at least one (16A) of the said annular ridges being formed at the end of an elastically deformable annular flange (18A) emerging from the said gasket, characterised in that the said annular flange (18A) extends generally at an angle relative to the axis of the gasket, the flange (18A) projecting not only from the corresponding transverse face (19A) of the gasket, but also from the inner peripheral face (15) thereof, and having, in axial section, a triangular profile with an acute apex angle to that the said flange (18A) is capable of acting in flexion.

2. An annular gasket according to claim 1, characterised in that the apex angle of the flange (18A) is preferably less than 40°.

3. An annular gasket according to either claim 1 or 2, characterised in that the other annular ridge (16B) is also formed at the end of an elastically deformable annular flange (18B).

4. A process for employing the annular gasket (10) according to any one of claims 1 to 3, of the kind wherein a suitable metered quantity of organic material to be moulded having been brought into position between two mould shells (17A, 17B) separated from each other by the annular gasket (10) either after bringing a single one of the mould shells into position, or bringing both of them into position, pressure is axially exerted on one of said mould shells (17A, 17B) while supporting the other, characterised in that in order to develop the pressure a movable finger (23) is employed, the travel of which is controlled.

**Patentansprüche**

1. Ringförmige Dichtung für das Giessen ophthalmischer Linsen aus organischem Material mit zwei an ihrer inneren Umfangsfläche axial im Abstand voneinander angeordneten ringförmigen Anschlägen (16A, 16B), welche dicht mit zwei Kokillenformen (17A, 17B) zusammenwirken, wobei wenigstens einer (16A) der ringförmigen Anschläge an seinem Ende mit einem ringförmigen Kragen (18A) ausgebildet ist, welcher elastisch verformbar an der Dichtung ist, dadurch gekennzeichnet, dass der ringförmige Kragen (18A) sich im wesentlichen schräg zur Achse der Dichtung erstreckt, dass der Kragen (18A) eine Auskragung nicht nur auf die entsprechende Querfläche (19A) der Dichtung aufweist, sondern auch auf die innere Umfangsfläche (15A) der Dichtung, und dass der Kragen im Achsschnitt ein dreieckiges Profil mit einem spitzen Scheitelwinkel aufweist, so dass der Kragen (18A) auf Biegung beansprucht werden kann.

2. Ringförmige Dichtung nach Anspruch 1, dadurch gekennzeichnet, dass der Scheitelwinkel des Kragens (18A) vorzugsweise ungefähr 40° beträgt.

3. Ringförmige Dichtung nach einem der Ansprüche 1 oder 2, dadurch gekennzeichnet, dass der andere ringförmige Anschlag (16B) ebenfalls am Ende eines elastisch verformbaren ringförmigen Kragens (18B) ausgebildet ist.

4. Verfahren zur Anwendung der ringförmigen Dichtung (10) nach einem der Ansprüche 1 bis 3, wobei eine geeignete Menge eines organischen Formmaterials zwischen die beiden Kokillenformen (17A, 17B) eingebracht wird, welche voneinander durch die ringförmige Dichtung (10) getrennt sind, wobei entweder eine einzige der Kokillenformen angeordnet ist oder wobei die eine und die andere der Kokillenformen angeordnet ist und wobei man einen Druck in Axialrichtung auf die eine der Kokillenformen (17A, 17B) ausübt, wobei sich die eine Kokillenform gegen die andere abstützt, dadurch gekennzeichnet, dass man zur Ausbildung des Druckes einen beweglichen Stempel (23), dessen Hub man regelt, betätigt.

FIG.1

FIG.2A

FIG.2B

FIG.2C

FIG.2D

FIG.2E

FIG.2F

FIG.3

FIG.4

FIG.5

FIG.6

0 015 202